# EUROPEAN PATENT APPLICATION

(11) **EP 3 633 082 A1**
(43) Date of publication of application: **08.04.2020**
(21) Application number: 18806724.3
(22) Date of filing: 22.03.2018
(51) Int. Cl.: C30B 29/38

(54) **NITRIDE SINGLE CRYSTAL**

(30) Priority: 23.05.2017 JP 2017102077
(71) Applicant: TDK Corporation, Tokyo 1036128 (JP)
(72) Inventor: OHIDO Atsushi, Tokyo 103-6128 (JP); KAWASAKI Katsumi, Tokyo 103-6128 (JP); YAMASAWA Kazuhito, Tokyo 103-6128 (JP)
(74) Representative: Epping - Hermann - Fischer
(86) International application number: PCT/JP2018/011429
(87) International publication number: WO 2018/216335

(57) **Abstract**

A nitride single crystal having high crystallinity is provided. A nitride single crystal 10 has a wurtzite crystal structure, and a content of boron is 0.5 ppm by mass or more and 251 ppm by mass or less.

## Description

### Technical Field

The present invention relates to a nitride single crystal.

### Background Art

Nitride single crystals (so-called nitride semiconductors) attract attention as materials of light-emitting devices which emit blue to ultraviolet short wavelength light or power transistors. Especially an aluminum nitride single crystal attracts attention as a material of the substrate of an ultraviolet light-emitting device. Nitride single crystals are produced, for example, by a vapor phase growth method such as a sublimation method or a halide vapor phase epitaxy (HVPE) method; or a liquid phase growth method such as a flux method (refer to the following Patent Literature 1 to 4).

In a sublimation method described in the following Patent Literature 1 and the like, a nitride which is a raw material is sublimated at high temperature, and the nitride is deposited on the surface of a seed crystal at low temperature and crystallized. Since the crystal growth rate is high in a sublimation method, the sublimation method is suitable to produce bulk crystals. However, a nitride single crystal is easily colored brown due to surplus deposition of specific atoms or molecules, or the like in the single crystal in the case of a sublimation method, and it is difficult to obtain a nitride single crystal having high crystallinity.

In a halide vapor phase epitaxy method described in the following Patent Literature 2 and the like, a nitride is deposited on the surface of a seed crystal and crystallized by reacting a gaseous chloride and ammonia. Although the coloring of the nitride single crystal is suppressed in the case of the halide vapor phase epitaxy method, it is difficult to obtain a nitride single crystal having few defects and high crystallinity.

In a flux method described in the following Patent Literature 3 and the like, a nitride single crystal is grown on the surface of a seed crystal in a liquid phase. According to a flux method, a single crystal having few defects is easily obtained theoretically as compared with the case of the vapor phase growth method. Methods for producing a nitride single crystal by a liquid phase epitaxy (LPE) method, which is one of flux methods, have been investigated until now. However, in a conventional liquid phase epitaxy method, a nitride single crystal having high crystallinity has not been obtained.

### Citation List

### Patent Literature

Patent Literature 1: Japanese Unexamined Patent Publication No. 2013-6740
Patent Literature 2: Japanese Unexamined Patent Publication No. 2010-89971
Patent Literature 3: Japanese Unexamined Patent Publication No. 2007-182333
Patent Literature 4: Japanese Unexamined Patent Publication No. H8-239752

### Summary of Invention

### Technical Problem

The present invention has been completed in light of the above-mentioned situation, and an object of the present invention is to provide a nitride single crystal having high crystallinity.

### Solution to Problem

A nitride single crystal according to one aspect of the present invention has a wurtzite crystal structure, and a content of boron in the nitride single crystal is 0.5 ppm by mass or more and 251 ppm by mass or less.

The content of boron in the above-mentioned nitride single crystal may be 1 ppm by mass or more and 52 ppm by mass or less.

The above-mentioned nitride single crystal may contain at least one element of Group 13.

The above-mentioned nitride single crystal may contain aluminum.

The above-mentioned nitride single crystal may be aluminum nitride.

The above-mentioned nitride single crystal may contain at least one element selected from the group consisting of iron, nickel, titanium, silicon, vanadium, copper, cobalt, manganese and chromium.

A total content of iron, nickel, titanium, silicon, vanadium, copper, cobalt, manganese and chromium in the above-mentioned nitride single crystal may be 1 ppm by mass or more and 100 ppm by mass or less.

The above-mentioned nitride single crystal may be a substrate wherein a thickness is 10 µm or more and 2 mm or less.

### Advantageous Effects of Invention

According to the present invention, a nitride single crystal having high crystallinity is provided.

### Brief Description of Drawings

[Figure 1] (a) in Figure 1 is a perspective view of a nitride single crystal structure (wurtzite crystal structure) according to one embodiment of the present invention, and (b) in Figure 1 is a perspective view of a boron nitride single crystal (hexagonal crystal) structure.
[Figure 2] Figure 2 is a schematic diagram showing a method for producing a nitride single crystal according to one embodiment of the present invention.

### Description of Embodiments

Suitable embodiments of the present invention will be described with reference to Figures hereinafter depending on the case. However, the present invention is not limited to the following embodiments at all. In Figures, the same or equivalent components are indicated with the same sign.

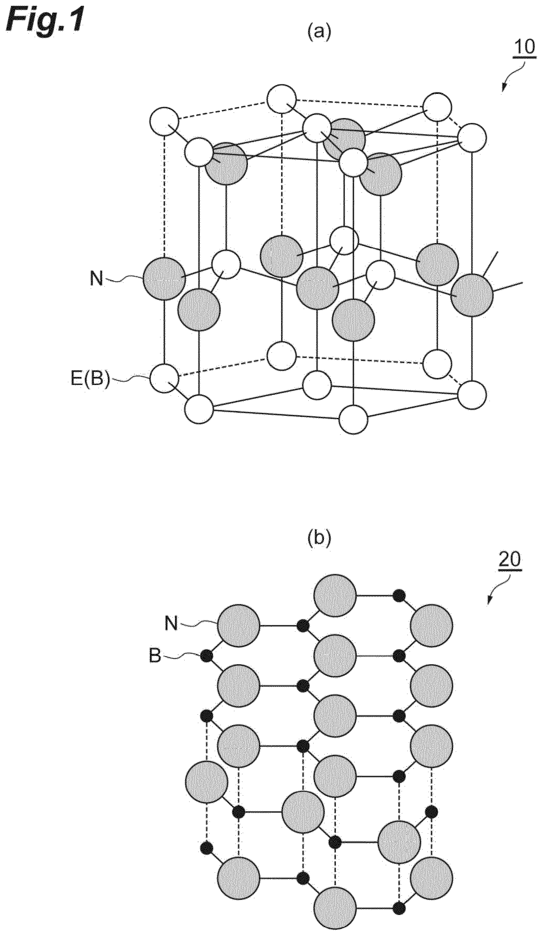

As shown in (a) in Figure 1, a nitride single crystal 10 according to the present embodiment has a wurtzite crystal structure. The nitride single crystal 10 is called a single crystal of a nitride of an element E (for example, EN). The nitride single crystal 10 may contain at least one element of Group 13. That is, the element E shown in (a) in Figure 1 may be at least one element of Group 13. The nitride single crystal 10 may be a single crystal of a nitride of at least one element of Group 13. The element of Group 13 (element E) contained in the nitride single crystal 10 may be at least one selected from the group consisting of aluminum (Al), gallium (Ga), indium (In) and thallium (T1). The nitride single crystal 10 may contain, for example, aluminum as an element of Group 13 (element E). The content of boron (B) in the nitride single crystal 10 according to the present embodiment is 0.5 ppm by mass or more and 251 ppm by mass or less.

Since the content of boron in the nitride single crystal 10 is very low as mentioned above, the composition of the nitride single crystal 10 may be approximately represented as AlₓGa_{y}In_{z}N. x + y +z is around 1, x is 0 or more and 1 or less, y is 0 or more and 1 or less, and z is 0 or more and 1 or less. The nitride single crystal 10 may be, for example, aluminum nitride (AlN). The nitride single crystal 10 may be, for example, gallium nitride (GaN). The nitride single crystal 10 may be, for example, indium nitride (InN). The nitride single crystal 10 may be, for example indium gallium nitride (InGaN).

As shown in (a) in Figure 1, a triangular pyramid in which nitrogen atoms or nitrogen ions (anions) are disposed at the four vertices is constituted in the nitride single crystal 10 having a wurtzite crystal structure. An atom of a trivalent element E or an ion (cation) of the element E is disposed at the center of this triangular pyramid. Meanwhile, as shown in (b) in Figure 1, a triangle in which nitrogen atoms or nitrogen ions are disposed at the three vertices at normal pressure is constituted in a boron nitride single crystal 20 (BN). A trivalent boron atom or a boron ion (cation) is disposed at the center of this triangle. The radius of a boron atom or a boron ion is smaller than the radius of a nitrogen atom or a nitrogen ion. Therefore, one boron atom or one boron ion fits in a space surrounded by three nitrogen atoms or three nitrogen ions. Consequently, a boron nitride single crystal has a planar hexagonal crystal structure. Since the nitride single crystal 10 according to the present embodiment contains a minute amount of boron, some atoms of the element E shown in (a) of Figure 1 are substituted with boron atoms. The radius of a boron atom or a boron ion is smaller than the radius of an atom of the element E or an ion of the element E. Therefore, a boron atom or a boron ion easily fits in the space surrounded by the four nitrogen atoms or nitrogen ions (the center of the triangular pyramid) as compared with an atom of the element E or an ion of element E in the same way as the case of the boron nitride single crystal. Consequently, in the nitride single crystal 10 containing boron, stress which acts on the crystal lattice is relaxed as compared with a nitride single crystal not containing boron, the distortion of the crystal structure is suppressed, and the crystallinity increases. The above effect resulting from boron is exhibited in a nitride single crystal 10 wherein the content of boron is 0.5 ppm by mass or more and 251 ppm by mass or less. In a nitride single crystal wherein the content of boron is less than 0.5 ppm by mass, boron can hardly suppress the distortion of the crystal structure. Therefore, the crystallinity of the nitride single crystal wherein the content of boron is less than 0.5 ppm by mass is inferior to the crystallinity of a nitride single crystal wherein the content of boron is 0.5 ppm by mass or more and 251 ppm by mass or less. Meanwhile, a nitride wherein the content of boron is more than 251 ppm by mass can hardly become a single crystal originally, and easily becomes a polycrystal. The surface roughness of the nitride wherein the content of boron is more than 251 ppm by mass is higher than the surface roughness of the nitride single crystal 10 wherein the content of boron is 0.5 ppm by mass or more and 251 ppm by mass or less. Therefore, a crystal of another compound (for example, compound semiconductor) can hardly be formed on the surface of the nitride crystal (polycrystal) wherein the content of boron is more than 251 ppm by mass. That is, the nitride crystal (polycrystal) wherein the content of boron is more than 251 ppm by mass can hardly be used as a substrate of light-emitting devices such as LEDs.

Improvement in the crystallinity of the nitride single crystal 10 is confirmed by a decrease in the half width of the rocking curve of the nitride single crystal 10 measured by X-ray diffraction (XRD) as mentioned below. It may be confirmed by a pole figure measured by XRD whether a nitride is a single crystal or not. It may be confirmed by in-plane diffractometry whether a nitride is a single crystal or not.

In a nitride having a wurtzite crystal structure, the radius of an aluminum atom or an aluminum ion (cation) is smaller than the radius of a gallium atom or a gallium ion, and approximate to the ion radius of a boron atom or a boron ion (cation). Therefore, the distortion of the crystal structure is easily relaxed by inclusion of boron in a nitride single crystal containing aluminum. Especially the distortion of the crystal structure is easily relaxed by inclusion of boron in an aluminum nitride single crystal.

The content of the boron in the nitride single crystal 10 may be 1 ppm by mass or more and 123 ppm by mass or less, 1 ppm by mass or more and 66 ppm by mass or less, 1 ppm by mass or more and 52 ppm by mass or less, 15 ppm by mass or more and 52 ppm by mass or less, or 20 ppm by mass or more and 52 ppm by mass or less. When the content of boron is in the above-mentioned range, the nitride single crystal 10 easily has high crystallinity. In other words, when the content of boron is in the above-mentioned range, the half width of the rocking curve of the nitride single crystal 10 easily decreases.

The above-mentioned nitride single crystal 10 may contain at least one element selected from the group consisting of iron (Fe), nickel (Ni), titanium (Ti), silicon (Si), vanadium (V), copper (Cu), cobalt (Co), manganese (Mn) and chromium (Cr). These elements have a different ion radius from elements of Group 13, and, for example, can fit in a wurtzite crystal structure as cations. Consequently, the distortion of the nitride single crystal 10 is further suppressed, and the half width of the rocking curve of the nitride single crystal 10 further decreases. At least one element selected from the group consisting of nickel, titanium, silicon, vanadium, copper, cobalt, manganese and chromium may be derived from, for example, a solvent (flux) used for producing the nitride single crystal 10.

The total content of iron, nickel, titanium, silicon, vanadium, copper, cobalt, manganese and chromium in the nitride single crystal 10 may be 1 ppm by mass or more and 100 ppm by mass or less. In this case, the distortion of the nitride single crystal 10 is further suppressed, and the half width of the rocking curve of the nitride single crystal 10 further decreases. For the same reason, the total content of iron, nickel, titanium, silicon, vanadium, copper, cobalt, manganese and chromium in the nitride single crystal 10 may be 1.3 ppm by mass or more and 59 ppm by mass or less.

The nitride single crystal 10 may be a substrate wherein the thickness is 10 µm or more and 2 mm or less. A substrate comprising the nitride single crystal 10 is formed by growing the nitride single crystal 10 containing boron on a flat surface of a seed crystal. In the early stage of crystal growth, since the crystal structure of the single crystal 10 tends to be influenced by the crystal structure of the seed crystal, the crystal structure of the single crystal 10 is easily distorted. However, when the thickness of the substrate of single crystal 10 reaches 10 µm or more with crystal growth, the distortion of the crystal structure tends to be relaxed by inclusion of boron, and the crystallinity of the single crystal 10 easily improves. However, in comparison with the single crystal of an oxide, defects in the nitride single crystal 10 easily occur during crystal growth, and the mechanical strength of the substrate of the nitride single crystal 10 tends to be low. Therefore, it is desirable for the thickness of the substrate comprising the nitride single crystal 10 to be 2 mm or less to suppress cracks of the substrate resulting from thermal distortion or stress. The thickness of the substrate comprising the nitride single crystal 10 may be 11 µm or more and 1758 µm or less.

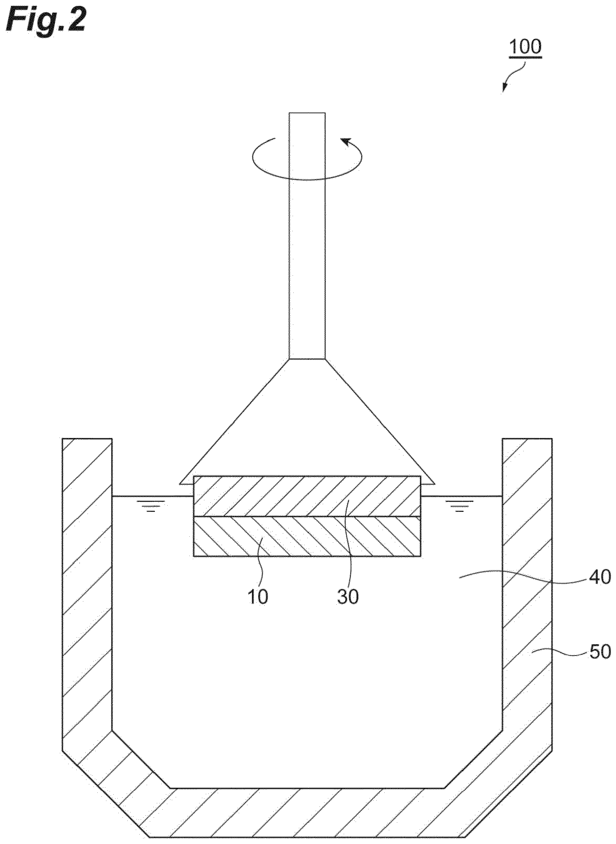

A method for producing a nitride single crystal 10 according to the present embodiment may be a flux method, which is a type of liquid phase growth method. The method for producing a nitride single crystal 10 may be performed, for example, using a production equipment 100 as shown in Figure 2. The method for producing a nitride single crystal 10 comprises: a step of preparing a solvent 40 containing elements which are raw materials of a nitride (metallic elements such as elements of Group 13) and boron; and a step of feeding nitrogen gas into the solvent 40, contacting the surface of a seed crystal 30 with the solvent 40, and growing a nitride single crystal 10 on the surface of the seed crystal 30. Details of the production method will be described hereinafter.

The solvent 40 may be called flux. The solvent 40 may contain an element of Group 13 such as aluminum, gallium, indium or thallium, and boron as raw materials of the nitride. The solvent 40 may contain at least one element selected from the group consisting of nickel, titanium, silicon, vanadium, copper, cobalt, manganese and chromium. The content of the boron in the nitride single crystal 10 can be controlled to 0.5 ppm by mass or more and 251 ppm by mass or less by adjusting the content of boron (for example, the number of moles) in the solvent 40 as mentioned below.

The solvent 40 may be prepared, for example, in the following procedure.

All of the raw materials of solvent 40 (elements constituting the solvent) may be simple substances (metal simple substances). The raw materials are weighed, and a crucible is charged with the raw materials. All the raw materials in the crucible are heated and melted at 1600 to 1800°C in an inert atmosphere in a vacuum chamber, and all the materials are stirred and mixed. A block (metal block) of a mixture of the raw materials is obtained by cooling the mixture of the melted raw materials to room temperature. The crucible is charged with the block of the mixture of the raw materials again, the mixture of the raw materials in the crucible 50 is melted in the vacuum chamber, and the mixture of the raw materials is stirred. Consequently, a homogeneous solvent 40 is prepared.

A nitride single crystal 10 may be grown in the following procedure.

Mixed gas of nitrogen and argon is fed into a vacuum chamber after deaeration in the vacuum chamber, and the solvent 40 in the crucible 50 is stirred while the solvent 40 is heated. Consequently, a solvent 40 in which nitrogen is dissolved homogenously is obtained. The atmospheric pressure in a vacuum chamber may be adjusted so that nitrogen in the solvent 40 is saturated. The feeding of nitrogen (mixed gas) into the vacuum chamber may be continued until the growth of the nitride single crystal 10 is completed. The temperature of the solvent 40 at the time of stirring the solvent 40 may be set as so high a temperature that all of the nitride and the solvent 40 is melted, and a solid (undissolved matter) does not remain on the liquid surface of the solvent 40 after stirring. The temperature of the solvent 40 at the time of stirring the solvent 40 may be, for example, 1500°C or more and 1800°C or less. The temperature of the solvent 40 at the time of stirring the solvent 40 is influenced by the structure of the heating part of a production equipment 100 (single crystal growth furnace), the ratio of nitrogen in the mixed gas, and the like. Therefore, the structure of the furnace, the ratio of nitrogen in mixed gas, the output power of the heating part, and the like may be determined so that the temperature of the solvent 40 at the time of stirring the solvent 40 (stirring temperature) is adjusted to a desired and predetermined temperature (the above-mentioned temperature range).

The solvent 40 is stirred, the temperature of the solvent 40 is then lowered gradually to the saturation temperature, at which a nitride begins to deposit, one surface of the seed crystal 30 is then contacted with the solvent 40 while the surface is rotated in the plane. Consequently, the nitride single crystal 10 begins to grow on the surface of the seed crystal 30. The temperature of the solvent 40 in the growth process of the nitride single crystal 10 (the above-mentioned saturation temperature) may be, for example, 1400°C or more and 1750°C or less. The temperature of the solvent 40 in the growth process of the nitride single crystal 10 (growth temperature) is influenced by the structure of the heating part of the production equipment 100 (single crystal growth furnace), the ratio of nitrogen in the mixed gas, and the like. Therefore, the structure of the heating part of production equipment 100 (single crystal growth furnace), the ratio of the nitrogen in mixed gas, the output power of the heating part, and the like may be determined and adjusted so that the temperature of solvent 40 in the growth process of nitride single crystal 10 be adjusted to a desired and predetermined temperature (saturation temperature) or less. Time for which the nitride single crystal 10 is grown may be, for example, several hours or more and tens of hours or less.

When a high frequency induction heating furnace is used as a single crystal growth furnace, it is difficult to measure the temperature of the solvent 40 in the crucible 50 correctly by a thermocouple. It is because the thermocouple itself generates heat by the action of high frequency in the high frequency induction heating furnace. Therefore, temperature conditions such as stirring temperature and growth temperature may be set and controlled by the repetition of the following experiments (trial and error). First, the output power of the heating part of the high frequency induction heating furnace is increased, and the raw materials in the crucible 50 are heated and melted. The melted raw materials (solvent 40) are stirred and cooled rapidly to room temperature, and it is observed whether undissolved matter on the liquid surface of the solvent 40 exists or not. When undissolved matter exists on the liquid surface of the solvent 40, the output power of the heating part is increased until the undissolved matter disappears on the liquid surface of solvent 40. The temperature of the solvent 40 heated at an output power at which undissolved matter disappears on the liquid surface of the solvent 40 is the stirring temperature. The temperature of the solvent 40 reaches the stirring temperature, the output power of the heating part is then reduced gradually, and the output power at which the nitride single crystal 10 begins to grow on the surface of the seed crystal 30 is determined. The temperature of the solvent 40 heated at output power at which the nitride single crystal 10 begins to grow is a saturation temperature (starting temperature of crystal growth). As mentioned above, the stirring temperature and the growth temperature can be indirectly controlled separately by adjusting the output power of the heating part of the high frequency induction heating furnace.

In a conventional flux method, since a solvent does not contain boron, microcrystals of a nitride easily deposit irregularly in the solvent. Therefore, in the conventional flux method, a nitride single crystal hardly grew on the surface of a seed crystal. Meanwhile, in the present embodiment, since a solvent 40 containing boron is used, the irregular deposition of the microcrystals in the solvent 40 is suppressed, and a nitride single crystal 10 wherein the crystallinity is high easily grows on the surface of a seed crystal 30 as compared with the conventional flux method.

The nitride single crystal 10 grown in the above procedure is taken out of the solvent 40 with the seed crystal 30 and cooled to room temperature. The nitride single crystal 10 is completed by removing metal (flux) adhering to the surface of the single crystal 10 by acid cleaning.

The seed crystal may be a nitride single crystal. A nitride single crystal to be used as a seed crystal may be produced by a method other than the above-mentioned method for producing a nitride single crystal (for example, a sublimation method). The seed crystal may be a nitride single crystal of an element of Group 13. The seed crystal may be a single crystal of aluminum nitride. The seed crystal may be a single crystal of sapphire or a single crystal of silicon carbide.

The nitride single crystal 10 according to the present embodiment may be used as a substrate which a deep ultraviolet light emitting diode such as a UVC LED or a DUV LED comprises. The nitride single crystal 10 may be used as a substrate which a semiconductor laser oscillator of an ultraviolet laser or the like comprises. The seed crystal 30 and the nitride single crystal 10 formed on the surface of the seed crystal 30 may be used as one substrate (integrated substrate). The nitride single crystal 10 according to an embodiment may be used, for example, for a power transistor.

### Examples

Although the present invention will be described in further detail below by Examples and Comparative Examples, the present invention is not limited by these Examples at all.

### (Example 1)

### <Production of AlN crystal>

The aluminum nitride (AlN) crystal of Example 1 was produced by performing the following steps in a vacuum chamber.

As raw materials of a solvent (flux), the simple substances (metal simple substances) of elements shown in the following table 1 were weighed, and a crucible made of alumina was charged with the simple substances. The total mass of the raw materials was adjusted to 250 g. All the raw materials were melted and integrated by mixing all the raw materials in the crucible and heating in an argon atmosphere at 1650°C. A block of a mixture of the raw materials was obtained by cooling the mixture of the melted raw materials to room temperature.

The crucible made of alumina was charged with the block of the mixture of the raw materials again. The block of the mixture of the raw materials in the crucible was melted by heating the block in a high frequency induction heating furnace. A homogeneous solvent was obtained by stirring the mixture of the melted raw materials using a tool for stirring provided at the top of the crucible. The tool for stirring was made of alumina.

The molar ratios of the elements in a solvent were adjusted to values shown in the following table 1 by weighing the above-mentioned raw materials (the simple substances of the elements). The symbols of elements in brackets ([]) in the following table 1 mean the numbers of moles or the content (unit: % by mol) of the elements in the solvent. For example, [Ti] means the number of moles or the content (unit: % by mol) of Ti in the solvent. Other symbols of elements in brackets also mean the same.

A plate-like seed crystal was fixed with a fixture provided at the top of the crucible, and the C surface of the seed crystal was opposed almost parallel to the liquid surface of the solvent. As the seed crystal, a plate of an aluminum nitride single crystal produced by a sublimation method was used. The size of the seed crystal was 10 mm × 10 mm × 0.3 mm. The fixture of the seed crystal was also made of alumina.

The atmospheric pressure in a vacuum chamber was reduced to 0.1 Pa or less by deaeration using a vacuum pump. A mixed gas obtained by mixing argon and nitrogen at a ratio (volume ratio) of 8 to 2 was fed into the vacuum chamber after the deaeration in the vacuum chamber, and the atmospheric pressure in the vacuum chamber was adjusted to 0.1 MPa. Then, a small amount of the mixed gas was continuously fed into the vacuum chamber until an AlN crystal grown in the vacuum chamber was taken out of the vacuum chamber.

The solvent in the crucible was stirred while the solvent was heated at so high a temperature that raw materials (metals) and AlN were dissolved completely using a high frequency induction heating furnace and the tool for stirring. Nitrogen derived from the mixed gas was homogeneously dissolved in the solvent by this heating and stirring, and nitrogen in the solvent was saturated. The temperature of the solvent was lowered to a saturation temperature, at which AlN begins to deposit, the C surface of the seed crystal 30 was then contacted on the liquid surface of the solvent 40, and the seed crystal 30 was continuously rotated in the C surface by rotating the fixture. An AlN crystal was grown on the C surface of the seed crystal by lowering the temperature of the solvent gradually. The AlN crystal growth was continued until the thickness of the AlN crystal reached a value shown in the following table 2.

The crystal grew until the thickness of the AlN crystal reached the value shown in the following table 2, the AlN crystal was then separated with the seed crystal from the solvent, and the AlN crystal and the seed crystal were cooled to room temperature. The AlN crystal and seed crystal after cooling were taken out of the fixture, and metal adhering to the AlN crystal was then removed by acid cleaning.

### <Analysis of AlN crystal>

The C surface (surface) of the AlN crystal of Example 1 produced in the above procedure was polished, and the C surface of the crystal was made even. It was confirmed that the AlN crystal grown on the surface of the seed crystal was a single crystal by X-ray diffractometry (2θ/θ method) and the measurement of a pole figure.

Then, the rocking curve of the plane (0002) of the AlN single crystal of Example 1 was measured by X-ray diffractometry using the CuKα1 line, and the half width (FWHM_{AlN}) of the rocking curve was determined. A rocking curve is the distribution of the intensity of diffracted X-rays measured by fixing 2θ at the diffraction peak position of the plane (0002) and scanning ω near diffraction conditions. 2θ is an angle which the incidence direction of incident X-rays (CuKα1 line) and the detection direction of diffracted X-rays form. ω is an incidence angle of the incident X-rays with respect to the (0002) plane (C surface) of the AlN single crystal. The half width of the rocking curve of the AlN single crystal (FWHM_{AlN}) of Example 1 was a value shown in the following table 2. However, since the absolute value of the half width of the rocking curve easily changes depending on the measuring device, the measurement condition, and the measurement accuracy, it is difficult to evaluate the crystallinities of a plurality of crystals relatively and correctly by comparing the absolute values of the half widths of rocking curves. Therefore, a sapphire single crystal produced by edge-defined film-fed growth (EFG) method was used as a standard sample for evaluating the crystallinity of the AlN single crystal as follows. This sapphire single crystal was a plate having the (0006) plane (C surface) direction.

The rocking curve of the plane (0006) (C surface) of the sapphire single crystal (standard sample) was measured by the same method as the above, and the half width of the rocking curve (FWHM_{Al2O3}) was determined. The half width ratio of the rocking curve of the AlN single crystal (FWHM_{AlN}/FWHM_{Al2O3}) of Example 1 was calculated by dividing the half width of the rocking curve of the AlN single crystal FWHM_{AlN} of Example 1 by the half width of the rocking curve of the sapphire single crystal FWHM_{Al2O3}. For example, when the half width of AlN FWHM_{AlN} is 0.12 deg, and the half width of sapphire FWHM_{Al2O3} is 0.10 deg, the half width ratio (FWHM_{AlN}/FWHM_{Al2O3}) is 1.2. As this half width ratio becomes nearer to 1.0, the AlN single crystal has as good crystal quality as the sapphire single crystal. That is, as the half width ratio of the rocking curve becomes nearer to 1.0, the crystallinity of the AlN single crystal becomes higher. The half width ratio of the rocking curve of the AlN single crystal of Example 1 was a value shown in the following table 2.

The composition of the AlN single crystal of Example 1 growing on the surface of the seed crystal was analyzed by secondary ion mass spectrometry (SIMS) after the above measurement using X-rays. As a result of SIMS, it was confirmed that the single crystal of Example 1 was AlN containing a minute amount of boron. The content of each element in the AlN single crystal of Example 1 was measured by SIMS. The content of each element in the AlN single crystal of Example 1 was values shown in the following table 2.

### (Examples 2 to 11 and Comparative Examples 1 to 3)

In Examples 2 to 11 and Comparative Examples 1 to 3, the simple substances of elements (metal simple substances) shown in the following table 1 were used as the raw materials of each solvent (flux). In Examples 2 to 11 and Comparative Examples 1 to 3, the molar ratio of each element in the solvent was adjusted to values shown in the following table 1. In Examples 2 to 11 and Comparative Examples 1 to 3, the ratio of argon to nitrogen in a mixed gas fed into a vacuum chamber was adjusted to the range of 9 to 1 to 6 to 4. The AlN crystals of Examples 2 to 11 and Comparative Examples 1 to 3 were produced individually in the same method as in Example 1 except for these items.

When the thickness of the AlN crystal was 20 µm or less, the surface of the aluminum nitride crystal was not polished. The AlN crystals of Examples 2 to 11 and Comparative Examples 1 to 3 were analyzed individually in the same method as in Example 1 except for this item.

As a result of the analysis, it was confirmed that each of the AlN crystals of Examples 2 to 11 and Comparative Examples 1 and 2 was a single crystal. Meanwhile, unevenness was formed on the surface of the AlN crystal of Comparative Example 3. As a result of the 2θ/θ method, in the XRD pattern of the AlN crystal of Comparative Example 3, there was a diffraction peak derived from a crystal plane other than the (0002) plane. Therefore, it was confirmed that the AlN crystal of Comparative Example 3 was a polycrystal.

The half widths of the rocking curves of the AlN single crystals (FWHM_{AlN}) of Examples 2 to 11 and Comparative Example 1 and 2 were values shown in the following table 2. The half width ratios of the rocking curves of the AlN single crystals (FWHM_{AlN}/FWHM_{Al2O3}) of Examples 2 to 11 and Comparative Example 1 and 2 were values shown in the following table 2.

**[Table 1]**

| Table 1 | Raw material of solvent | Molar ratio of each element (-) | | | |
|---|---|---|---|---|---|
| - | - | [Ti]/([Fe]+[Ti]) | [Al]/[(Fe]+[Ti]) | [B]/((Fe]+(Ti]) | - |
| Example 1 | Al, B, Fe,Ti | 0.02 | 0.01 | 0.05 | - |
| Example 2 | Al, B, Fe,Ti | 0.02 | 0.01 | 0.55 | - |
| Example 3 | Al, B, Fe,Ti | 0.02 | 0.01 | 1.52 | - |
| Example 4 | Al, B, Fe,Ti | 0.02 | 0.01 | 1.80 | - |
| - | - | [Ti]/([Ni]+[Ti]) | [Al]/([Ni]+[Ti]) | [B]/([Ni]+[Ti]) | - |
| Example 5 | Al, B, Ni, Ti | 0.02 | 0.04 | 0.02 | - |
| Example 6 | Al, B, Ni, Ti | 0.02 | 0.01 | 2.30 | - |
| - | - | [V]/([Fe]+[V]) | [Al]/([Fe]+[V]) | [B]/([Fe]+[V]) | - |
| Example 7 | Al, B, Fe, V | 0.05 | 0.02 | 0.15 | - |
| - | - | [V]/([Ni]+[V]) | [Al]/([Ni]+[V]) | [B]/([Ni]+[V]) | - |
| Example 8 | Al, B, Ni, V | 0.30 | 0.03 | 0.80 | - |
| - | - | [Si]/([Cu]+[Si]+[Ti]) | [Ti]/([Cu]+[Si]+[Ti]) | [Al]/([Cu]+[Si]+[Ti]) | [B]/([Cu]+rSi]+[Ti]) |
| Example 9 | Al, B, Cu, Si, Ti | 0.42 | 0.02 | 0.01 | 0.75 |
| - | - | [Co]/([Fe]+[Co]+[Ti]) | [Ti]/([Fe]+[Co]+[Ti]) | [Al]/([Fe]+[Co]+[Ti]) | [B]/([Fe]+[Co]+[Ti]) |
| Example 10 | Al, B, Fe, Co, Ti | 0.35 | 0.02 | 0.01 | 0.75 |
| - | - | [Mn]/([Fe]+[Mn]+[Cr]) | [Cr]/([Fe]+[Mn]+[Cr]) | [Al]/([Fe]+[Mn]+[Cr]) | [B]/([Fe]+[Mn]+[Cr]) |
| Example 11 | AL B, Fe, Mn, Cr | 0.25 | 0.15 | 0.02 | 0.75 |
| - | - | [V]/([Fe]+[V]) | [Al]/([Fe]+[V]) | [B]/([Fe]+[V]) | - |
| Comparative Example 1 | Al, B, Fe, V | 0.05 | 0.04 | 0.00 | - |
| Comparative Example 2 | Al, B, Fe, V | 0.05 | 0.04 | 0.01 | - |
| Comparative Example 3 | Al, B, Fe, V | 0.05 | 0.01 | 2.60 | - |

**[Table 2]**

| Table 2 | Content of element (ppm by mass) | | | | | Thickness (µm) | Crystallinity | Half width (deg.) | Half width ratio (-) |
|---|---|---|---|---|---|---|---|---|---|
| - | B | Fe | Ti | - | Fe+Ti | | | | |
| Example 1 | 1 | 94 | 6 | - | 100 | 56 | Single crystal | 0.212 | 2.12 |
| Example 2 | 20 | 42 | 3 | - | 45 | 80 | Single crystal | 0.110 | 1.10 |
| Example 3 | 52 | 16 | 2 | - | 18 | 112 | Single crystal | 0.124 | 1.24 |
| Example 4 | 123 | 5 | 1 | - | 6 | 15 | Single crystal | 0.341 | 3.41 |
| - | B | Ni | Ti | - | Ni+Ti | - | - | - | - |
| Example 5 | 0.5 | 0.8 | 0.2 | - | 1.0 | 13 | Single crystal | 0.440 | 4.40 |
| Example 6 | 251 | 1 | 0.3 | - | 1.3 | 11 | Single crystal | 0.476 | 4.76 |
| - | B | Fe | V | - | Fe+V | - | - | - | - |
| Example 7 | 15 | 49 | 3 | - | 52 | 925 | Single crystal | 0.136 | 1.36 |
| - | B | Ni | V | - | Ni+V | - | - | - | - |
| Example 8 | 1 | 23 | 6 | - | 29 | 1758 | Single crystal | 0.210 | 2.10 |
| - | B | Cu | Si | Ti | Cu+Si+Ti | - | - | - | - |
| Example9 | 33 | 10 | 25 | 4 | 39 | 12 | Single crystal | 0.195 | 1.95 |
| - | B | Fe | Co | Ti | Fe+Co+Ti | - | - | - | - |
| Example 10 | 66 | 33 | 21 | 5 | 59 | 85 | Single crystal | 0.211 | 2.11 |
| - | B | Fe | Mn | Cr | Fe+Mn+Cr | - | - | - | - |
| Example 11 | 58 | 33 | 15 | 5 | 53 | 105 | Single crystal | 0.201 | 2.01 |
| - | B | Fe | V | - | Fe+V | - | - | - | - |
| Comparative Example 1 | 0 | 652 | 6 | - | 658 | 28 | Single crystal | 2.120 | 21.20 |
| Comparative Example 2 | 0.3 | 641 | 6 | - | 647 | 31 | Single crystal | 1.807 | 18.07 |
| Comparative Example 3 | 280 | 12 | 2 | - | 14 | 20 | Polycrystal | - | - |

### Industrial Applicability

A nitride single crystal according to the present invention is used, for example, as a substrate which light emitting diodes comprise.

### Reference Signs List

10: nitride single crystal, 20: boron nitride single crystal, 30: seed crystal, 40: solution of raw materials, 50: crucible, 100: device for producing nitride single crystal.

## Claims

1. A nitride single crystal having a wurtzite crystal structure,
wherein a content of boron is 0.5 ppm by mass or more and 251 ppm by mass or less.

2. The nitride single crystal according to claim 1,
wherein the content of boron is 1 ppm by mass or more and 52 ppm by mass or less.

3. The nitride single crystal according to claim 1 or 2, comprising: at least one element of Group 13.

4. The nitride single crystal according to any one of claims 1 to 3, comprising:
aluminum.

5. The nitride single crystal according to any one of claims 1 to 4, wherein the nitride single crystal is aluminum nitride.

6. The nitride single crystal according to any one of claims 1 to 5, comprising:
at least one element selected from the group consisting of iron, nickel, titanium, silicon, vanadium, copper, cobalt, manganese and chromium.

7. The nitride single crystal according to any one of claims 1 to 6, wherein a total content of iron, nickel, titanium, silicon, vanadium, copper, cobalt, manganese and chromium is 1 ppm by mass or more and 100 ppm by mass or less.

8. The nitride single crystal according to any one of claims 1 to 7, wherein the nitride single crystal is a substrate wherein a thickness is 10 µm or more and 2 mm or less.
